# EUROPEAN PATENT APPLICATION

(11) **EP 4 700 754 A1**
(43) Date of publication of application: **25.02.2026**
(21) Application number: 25196656.0
(22) Date of filing: 19.08.2025
(51) Int. Cl.: G09G 3/20, G11C 19/28

(54) **GATE DRIVER AND DISPLAY DEVICE INCLUDING THE GATE DRIVER**

(30) Priority: 23.08.2024 KR 20240113374
(71) Applicant: Samsung Display Co., Ltd., Yongin-si, Gyeonggi-do 17113 (KR)
(72) Inventor: Jeong, Ilhun, Yongin-si, Gyeonggi-do (KR)
(74) Representative: Gulde & Partner

(57) **Abstract**

A gate driver includes a plurality of stages. Each of the plurality of stages includes an input circuit configured to provide an input signal to a control node in response to a first clock signal, a first inversion control circuit configured to control a voltage of an inversion control node in response to a voltage of the control node, and a gate output circuit configured to output a gate signal in response to the voltage of the control node and the voltage of the inversion control node.

## Description

### BACKGROUND

### 1. Field

Embodiments of the inventive concept relates to a gate driver, a display device including the gate driver. More particularly, the inventive concept relates to a gate driver and a display device for reducing a power consumption and a dead space.

### 2. Description of the Related Art

In general, a display device includes a display panel and a display panel driver. The display panel includes gate lines, data lines, and pixels. The display panel driver includes a gate driver for providing a gate signal to the gate lines, a data driver for providing a data voltage to the data lines, and a driving controller for controlling the gate driver and the data driver.

### SUMMARY

The gate driver includes a plurality of stages, and each of the stages has a plurality of configurations. For example, the configurations may be transistors, signal lines, and voltage lines. As the configurations increase, a power consumption of the gate driver may increase and a dead space may be larger.

Embodiments of the inventive concept provide a gate driver for simplify configurations to reduce a power consumption and a dead space.

In an embodiment of a gate driver according to the inventive concept, the gate driver includes a plurality of stages. Each of the plurality of stages includes an input circuit configured to provide an input signal to a control node in response to a first clock signal, a first inversion control circuit configured to control a voltage of an inversion control node in response to a voltage of the control node, and a gate output circuit configured to output a gate signal in response to the voltage of the control node and the voltage of the inversion control node.

In an embodiment, the input circuit may include a first transistor including a gate electrode receiving the first clock signal, a first electrode receiving the input signal, and a second electrode connected to the control node, the first inversion control circuit includes a second transistor including a gate electrode connected to the control node, a first electrode, and a second electrode connected to the inversion control node, and the gate output circuit includes a fourth transistor including a gate electrode connected to the inversion control node, a first electrode receiving a first gate voltage having a first level which is relatively high, and a second electrode connected to a gate output node from which the gate signal is output, and a fifth transistor including a gate electrode connected to the control node, a first electrode receiving a second clock signal, and a second electrode connected to the gate output node.

The each of the plurality of stages may operate in a duration in which the input signal has a low level, e.g., logic low level and in a duration in which the input signal has a high level, e.g. logic high. If the input signal has a low level, the first clock signal may have the low level and the second clock signal may have the high level. If the input signal has the high level, the first clock signal may have the high level and the second clock signal may have the low level or the first clock signal may have the low level, and the second clock signal has the high level.

In an embodiment, the each of the plurality of stages may further include a second inversion control circuit configured to control the voltage of the inversion control node in response to the first clock signal, and the second inversion control circuit includes a third transistor including a gate electrode receiving the first clock signal, a first electrode, and a second electrode connected to the inversion control node.

In an embodiment, the first to fifth transistors may be p-type metal oxide semiconductor ("PMOS") transistors.

In an embodiment, the gate output circuit may further include a first capacitor including a first electrode receiving the first gate voltage and a second electrode connected to the inversion control node.

In an embodiment, the gate output circuit may further include a first electrode connected to the gate output node and a second capacitor connected to the control node.

In an embodiment, the first electrode of the second transistor may receive the first clock signal, and the first electrode of the third transistor may receive the first clock signal.

In an embodiment, the control node may include a first control node and a second control node, the each of the plurality of stages may further include a node division circuit disposed between the first control node and the second control node and configured to divide the first control node and the second control node, and the node division circuit may include a sixth transistor including a gate electrode receiving the first clock signal, a first electrode connected to the first control node, and a second electrode connected to the second control node.

In an embodiment, the first electrode of the second transistor may receive the first clock signal, and the first electrode of the third transistor may receive a second gate voltage having a second level lower than the first level of the first gate voltage.

In an embodiment, the control node may include a first control node and a second control node, the each of the plurality of stages may further include a node division circuit disposed between the first control node and the second control node and configured to divide the first control node and the second control node, and the node division circuit may include a sixth transistor including a gate electrode receiving the second gate voltage, a first electrode connected to the first control node, and a second electrode connected to the second control node.

In an embodiment, the first electrode of the third transistor may receive the first clock signal, and the first inversion control circuit may further include a seventh transistor including a gate electrode receiving the second clock signal, a first electrode receiving the first gate voltage, and a second electrode connected to the first electrode of the second transistor.

In an embodiment, the control node may include a first control node and a second control node, the each of the plurality of stages may further include a node division circuit disposed between the first control node and the second control node and configured to divide the first control node and the second control node, and the node division circuit may include a sixth transistor including a gate electrode receiving the first clock signal, a first electrode connected to the first control node, and a second electrode connected to the second control node.

In an embodiment, the first electrode of the third transistor may receive a second gate voltage having a second level lower than the first level of the first gate voltage, and the first inversion control circuit may further include a seventh transistor including a gate electrode receiving the second clock signal, a first electrode receiving the first gate voltage, and a second electrode connected to the first electrode of the second transistor.

In an embodiment, the control node may include a first control node and a second control node, the each of the plurality of stages may further include a node division circuit disposed between the first control node and the second control node and configured to divide the first control node and the second control node, and the node division circuit may include a sixth transistor including a gate electrode receiving the second gate voltage, a first electrode connected to the first control node, and a second electrode connected to the second control node.

Further according to an embodiment, a display device comprising a display panel including pixels, a data driver providing a data voltage to the pixels, a gate driver providing a gate voltage to the pixels and a driving controller controlling the data driver and the gate driver. The gate driver may include the features defined in par. [0005] to [0019].According to the gate driver and the display device, theymay have fewer configurations (e.g., transistors, signal lines, and voltage lines). Accordingly, a power consumption and a dead space of the gate driver may be reduced.

### BRIEF DESCRIPTION OF THE DRAWINGS

The above and other features of embodiments of the inventive concept will become more apparent by describing in detailed embodiments thereof with reference to the accompanying drawings, in which:
FIG. 1 is a block diagram showing an embodiment of a display device according to the inventive concept.
FIG. 2 is a block diagram showing a gate driver of FIG. 1;
FIG. 3 is a circuit diagram showing an embodiment of a stage of FIG. 2;
FIG. 4 is a timing diagram showing an input signal, a first clock signal, a second clock signal, a voltage of a control node, a voltage of an inversion control node, and a gate signal of FIG. 3;
FIG. 5 is a circuit diagram showing an operation of a stage of FIG. 3 in a first duration of FIG. 4;
FIG. 6 is a circuit diagram showing an operation of a stage of FIG. 3 in a second duration of FIG. 4;
FIG. 7 is a circuit diagram showing an operation of a stage of FIG. 3 in a third duration of FIG. 4;
FIG. 8 is a circuit diagram showing an embodiment of a stage of FIG. 2;
FIG. 9 is a circuit diagram showing an embodiment of a stage of FIG. 2;
FIG. 10 is a circuit diagram showing an embodiment of a stage of FIG. 2;
FIG. 11 is a circuit diagram showing an embodiment of a stage of FIG. 2;
FIG. 12 is a circuit diagram showing an embodiment of a stage of FIG. 2;
FIG. 13 is a circuit diagram showing an embodiment of a stage of FIG. 2;
FIG. 14 is a circuit diagram showing an embodiment of a stage of FIG. 2;
FIG. 15 is a block diagram showing an electronic device; and
FIG. 16 is a diagram showing an embodiment in which an electronic device of FIG. 15 is implemented as a smart phone.

### DETAILED DESCRIPTION

Hereinafter, the inventive concept will be described in more detail with reference to the accompanying drawings.

It will be understood that when an element is referred to as being "on" another element, it may be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, the singular forms "a," "an," and "the" are intended to include the plural forms, including "at least one," unless the content clearly indicates otherwise. "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, operations, elements, and/or components, but do not preclude the presence or addition of one or more other features, regions, integers, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," may therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" may, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The term such as "about" may mean within one or more standard deviations, or within ± 30%, 20%, 10%, 5% of the stated value, for example.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

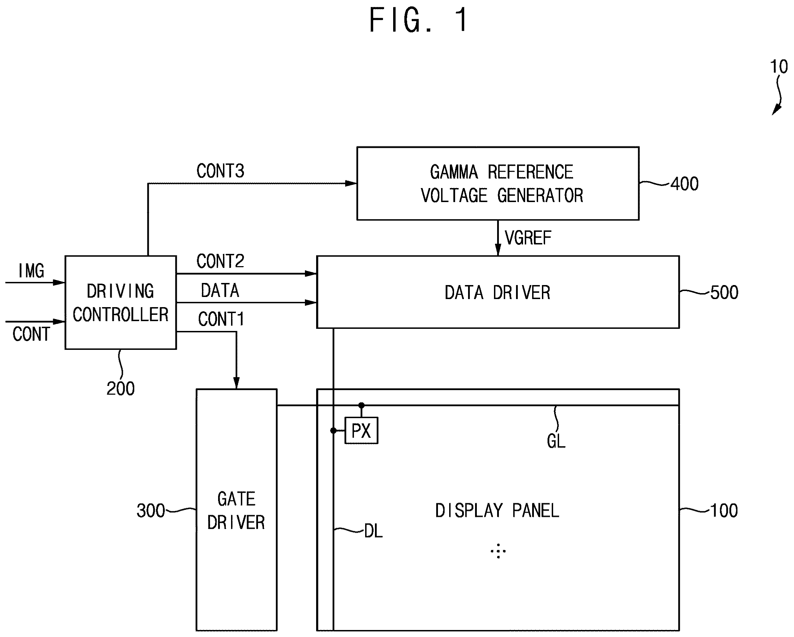

FIG. 1 is a block diagram showing an embodiment of a display device 10 according to the inventive concept.

Referring to FIG. 1, a display device 10 may include a display panel 100 and a display panel driver. The display panel driver may include a driving controller 200, a gate driver 300, a gamma reference voltage generator 400, and a data driver 500.

The display panel 100 may include a display area for displaying an image and a peripheral area disposed next (adjacent) to the display area.

The display panel 100 may include pixels PX connected to gate lines GL, data lines DL, and pixels PX electrically connected to each of the gate lines GL and the data lines DL. The gate lines GL may extend in a first direction, and the data lines DL may extend in a second direction intersecting the first direction.

The driving controller 200 may receive input image data IMG and an input control signal CONT from an external device (not shown). In an embodiment, the input image data IMG may include red image data, green image data, and blue image data, for example. The input image data IMG may include white image data. The input image data IMG may include magenta image data, yellow image data, and cyan image data. The input control signal CONT may include a master clock signal and a data enable signal. The input control signal CONT may further include a vertical synchronization signal and a horizontal synchronization signal.

The driving controller 200 may generate a first control signal CONT1, a second control signal CONT2, a third control signal CONT3, and a data signal DATA based on the input image data IMG and the input control signal CONT.

The driving controller 200 may generate the first control signal CONT1 for controlling an operation of the gate driver 300 based on the input control signal CONT, and output the first control signal CONT1 to the gate driver 300. The first control signal CONT1 may include a vertical start signal and a gate clock signal.

The driving controller 200 may generate the second control signal CONT2 for controlling an operation of the data driver 500 based on the input control signal CONT, and output the second control signal CONT2 to the data driver 500. The second control signal CONT2 may include a horizontal start signal and a load signal.

The driving controller 200 may generate the data signal DATA based on the input image data IMG. The driving controller 200 may output the data signal DATA to the data driver 500.

The driving controller 200 may generate the third control signal CONT3 for controlling an operation of the gamma reference voltage generator 400 based on the input control signal CONT, and output the third control signal CONT3 to the gamma reference voltage generator 400.

The gate driver 300 may generate gate signals for driving the gate lines GL in response to the first control signal CONT1 received from the driving controller 200. The gate driver 300 may sequentially output the gate signals to the gate lines GL in units of rows.

The gamma reference voltage generator 400 may generate a gamma reference voltage VGREF based on the third control signal CONT3 received from the driving controller 200. The gamma reference voltage generator 400 may provide the gamma reference voltage VGREF to the data driver 500. The gamma reference voltage VGREF may have a value corresponding to each data signal DATA.

In an embodiment, the gamma reference voltage generator 400 may be disposed within the driving controller 200 or within the data driver 500, for example.

The data driver 500 may receive the second control signal CONT2 and the data signal DATA from the driving controller 200, and convert the data signal DATA into a data voltage having an analog type. The data driver 500 may output the data voltage to the data line DL.

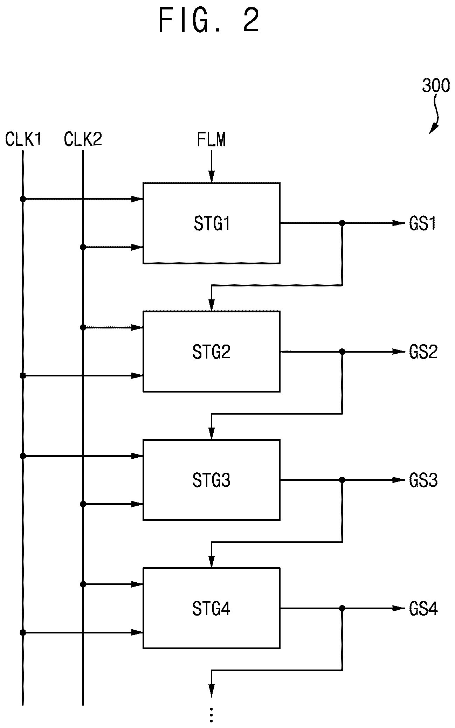

FIG. 2 is a block diagram showing a gate driver 300 of FIG. 1.

Referring to FIG. 2, a gate driver 300 may include a plurality of stages STG1, STG2, STG3, STG4, ...., etc. The stages STG1, STG2, STG3, STG4, ... may receive a gate start signal FLM, a first clock signal CLK1, and a second clock signal CLK2. The stages STG1, STG2, STG3, STG4, ..., etc., may sequentially output gate signals GS1, GS2, GS3, GS4, ...., etc. The first clock signal CLK1 and the second clock signal CLK2 are included in a first control signal CONT1 which is output from a driving controller 200 to a gate driver 300.

The first stage STG1 may receive the gate start signal FLM as an input signal, and subsequent stages STG2, STG3, ..., etc., may receive the gate signals GS1, GS2, GS3, GS4, ..., etc., as the input signal. The gate stark signal FLM is included in the first control signal CONT1 which is output from the driving controller 200 to the gate driver 300.

In an embodiment, the first stage STG1 may receive the gate start signal FLM as the input signal in response to the first clock signal CLK1, for example. The first stage STG1 may output the second clock signal CLK2 as the first gate signal GS1.

In an embodiment, a second stage STG2 may receive the first gate signal GS1 as the input signal in response to the second clock signal CLK2, for example. The second stage STG2 may output the first clock signal CLK1 as a second gate signal GS2.

In an embodiment, a third stage STG3 may receive the second gate signal GS2 as the input signal in response to the first clock signal CLK1, for example. The third stage STG3 may output the second clock signal CLK2 as a third gate signal GS3.

In an embodiment, a fourth stage STG4 may receive the third gate signal GS3 as the input signal in response to the second clock signal CLK2, for example. The fourth stage STG4 may output the first clock signal CLK1 as a fourth gate signal GS4.

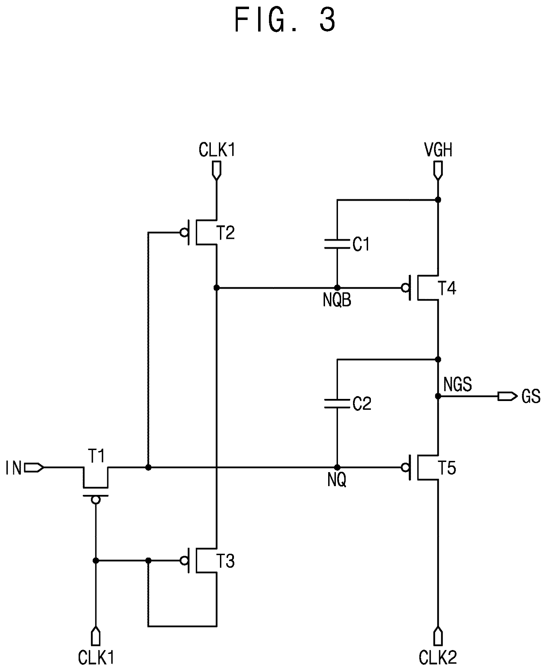

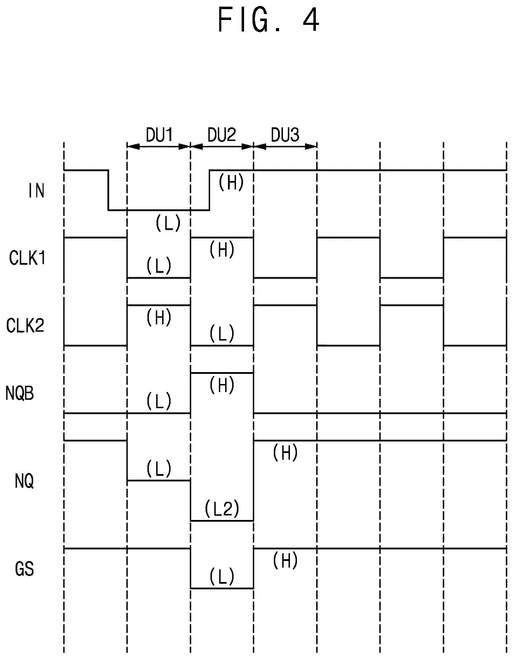

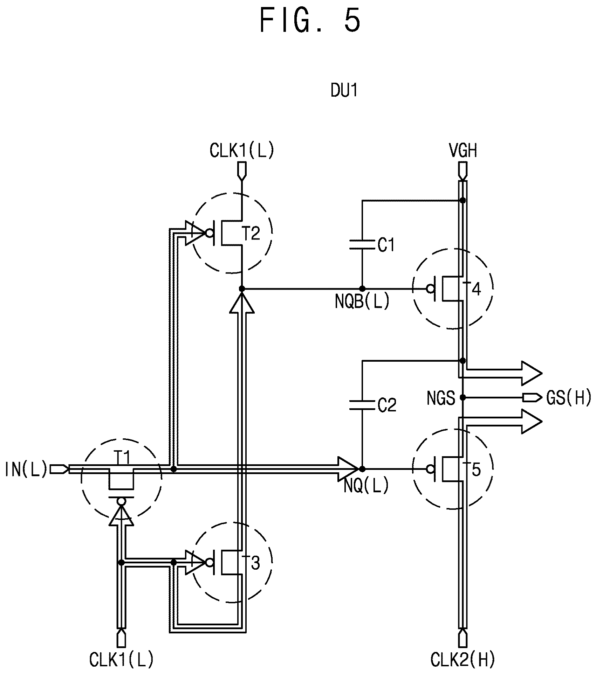

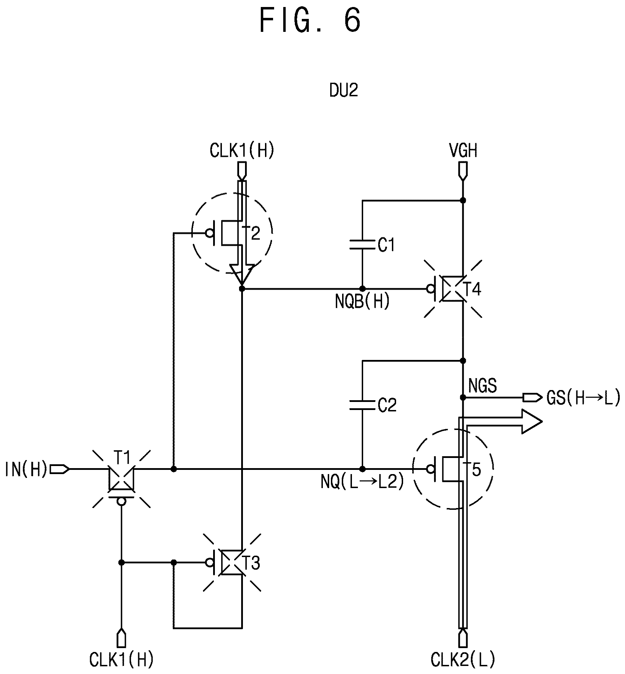

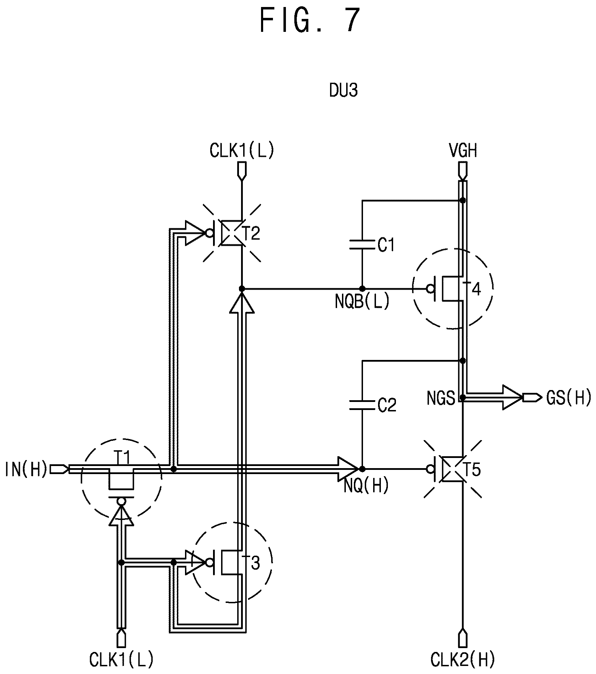

FIG. 3 is a circuit diagram showing an embodiment of a stage of FIG. 2. FIG. 4 is a timing diagram showing an input signal IN, a first clock signal CLK1, a second clock signal CLK2, a voltage of a control node NQ, a voltage of an inversion control node NQB, and a gate signal GS of FIG. 3. FIG. 5 is a circuit diagram showing an operation of a stage of FIG. 3 in a first duration DU1 of FIG. 4. FIG. 6 is a circuit diagram showing an operation of a stage of FIG. 3 in a second duration DU2 of FIG. 4. FIG. 7 is a circuit diagram showing an operation of a stage of FIG. 3 in a third duration DU3 of FIG. 4.

Referring to FIG. 3, a gate driver 300 in embodiments of the inventive concept may include a plurality of stages. Each stage may include an input circuit, a first inversion control circuit, a second inversion control circuit, and a gate output circuit. The term "circuit" may refer to an electrical element of each stage. That is, each stage may include an input element, a first inversion control element, a second inversion control element, and a gate output element.

The input circuit may provide an input signal IN to a control node NQ in response to a first clock signal CLK1, and the input circuit may include a first transistor T1. The first inversion control circuit may control a voltage of an inversion control node NQB in response to the first clock signal CLK1, and the first inversion control circuit may include a second transistor T2. The second inversion control circuit may control the voltage of the inversion control node NQB in response to the voltage of the control node NQ, and the second inversion control circuit may include a third transistor T3. The gate output circuit may output a gate signal GS in response to the voltage of the control node NQ and the voltage of the inversion control node NQB, and the gate output circuit may include a fourth transistor T4, a fifth transistor T5, a first capacitor C1, and a second capacitor C2. The first to fifth transistors T1 to T5 may be PMOS transistors.

The first transistor T1 may include a gate electrode receiving the first clock signal CLK1, a first electrode receiving the input signal IN, and a second electrode connected to the control node NQ.

The second transistor T2 may include a gate electrode connected to the control node NQ, a first electrode, and a second electrode connected to the inversion control node NQB. In an embodiment, the first electrode of the second transistor T2 may receive the first clock signal CLK1.

The third transistor T3 may include a gate electrode receiving the first clock signal CLK1, a first electrode, and a second electrode connected to the inversion control node NQB. In an embodiment, the first electrode of the third transistor T3 may receive the first clock signal CLK1.

The fourth transistor T4 may include a gate electrode connected to the inversion control node NQB, a first electrode receiving a relatively high gate voltage (also referred to as a first gate voltage) VGH, and a second electrode connected to a gate output node NGS from which the gate signal GS is output.

The fifth transistor T5 may include a gate electrode connected to the control node NQ, a first electrode receiving a second clock signal CLK2, and a second electrode connected to the gate output node NGS.

The first capacitor C1 may include a first electrode receiving the relatively high gate voltage VGH and a second electrode connected to the inversion control node NQB.

The second capacitor C2 may include a first electrode connected to the gate output node NGS and a second electrode connected to the control node NQ.

Referring to FIGS. 4 and 5, in a first duration DU1, the input signal IN may have a relatively low level L, the first clock signal CLK1 may have the relatively low level (also referred to as a second level) L, e.g., logic low level, and the second clock signal CLK2 may have a relatively high level (also referred to as a first level) H, e.g., logic high level.

The first transistor T1 may be turned on in response to the first clock signal CLK1 having the relatively low level L to provide the input signal IN having the relatively low level L to the control node NQ. Therefore, the voltage of the control node NQ may have the relatively low level L.

The second transistor T2 may be turned on in response to the voltage of the control node NQ having the relatively low level L to provide the first clock signal CLK1 having the relatively low level L to the inversion control node NQB. Therefore, the voltage of the inversion control node NQB may have the relatively low level L.

The third transistor T3 may be turned on in response to the first clock signal CLK1 having the relatively low level L to provide the first clock signal CLK1 having the relatively low level L to the inversion control node NQB. Therefore, the voltage of the inversion control node NQB may have the relatively low level L.

The fourth transistor T4 may be turned on in response to the voltage of the inversion control node NQB having the relatively low level L to provide the relatively high gate voltage VGH to the gate output node NGS. Therefore, the gate signal GS may have the relatively high level H.

The fifth transistor T5 may be turned on in response to the voltage of the control node NQ having the relatively low level L and provide the second clock signal CLK2 having the relatively high level H to the gate output node NGS. Therefore, the gate signal GS may have the relatively high level H.

Referring to FIG. 4 and FIG. 6, in a second duration DU2, the input signal IN may have the relatively high level H, the first clock signal CLK1 may have the relatively high level H, and the second clock signal CLK2 may have the relatively low level L.

The first transistor T1 may be turned off in response to the first clock signal CLK1 having the relatively high level H. The third transistor T3 may be turned off in response to the first clock signal CLK1 having the relatively high level H. Therefore, the voltage of the control node NQ may maintain the relatively low level L.

The second transistor T2 may be turned on in response to the voltage of the control node NQ having the relatively low level L to provide the first clock signal CLK1 having the relatively high level H to the inversion control node NQB. Therefore, the voltage of the inversion control node NQB may have the relatively high level H.

The fourth transistor T4 may be turned off in response to the voltage of the inversion control node NQB having the relatively high level H.

The fifth transistor T5 may be turned on in response to the voltage of the control node NQ having the relatively low level L to provide the second clock signal CLK2 having the relatively low level L to the gate output node NGS.

In this case, the gate signal GS may have the relatively high level H in the first duration DU1 and the relatively low level L in the second duration DU2. Since the second capacitor C2 maintains a voltage difference between two electrodes, when the gate signal GS decreases from the relatively high level H to the relatively low level L, the voltage of the control node NQ may decrease by a changed voltage of the gate signal GS. Therefore, the voltage of the control node NQ may decrease from the relatively low level L to the second relatively low level L2. Here, the second relatively low level L2 may be lower than the relatively low level L.

Referring to FIG. 4 and FIG. 7, in a third duration DU3, the input signal IN may have the relatively high level H, the first clock signal CLK1 may have the relatively low level L, and the second clock signal CLK2 may have the relatively high level H.

The first transistor T1 may be turned on in response to the first clock signal CLK1 having the relatively low level L and may provide the input signal IN having the relatively high level H to the control node NQ. Therefore, the voltage of the control node NQ may have the relatively high level H.

The second transistor T2 may be turned off in response to the voltage of the control node NQ having the relatively high level H.

The third transistor T3 may be turned on in response to the first clock signal L having the relatively low level L and provide the first clock signal L having the relatively low level L to the inversion control node NQB. Therefore, the voltage of the inversion control node NQB may have the relatively low level L.

The fourth transistor T4 may be turned on in response to the voltage of the inversion control node NQB having the relatively low level L and provide the relatively high gate voltage VGH to the gate output node NGS. Therefore, the gate signal GS may have the relatively high level H.

The fifth transistor T5 may be turned off in response to the voltage of the control node NQ having the relatively high level H.

As such, the gate driver 300 may include five transistors, two capacitors, two clock signals, and one gate voltage. Accordingly, configurations may be simplified, and a power consumption and a dead space of the gate driver 300 may be reduced.

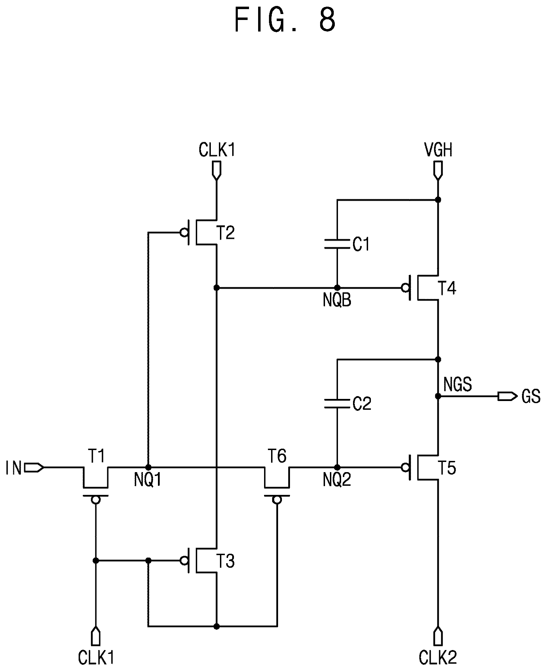

In FIGS. 3 to 7, an embodiment of the stage of FIG. 2 is described. In FIGS. 8 to 14, other embodiments of the stage of FIG. 2 are described. Circuit diagrams of FIGS. 8 to 14 are similar in configurations to the circuit diagram of FIG. 3, and operations of the circuit diagrams of FIGS. 8 to 14 are similar to the operation of the circuit diagram of FIG. 3. Therefore, a description of the operations of the circuit diagrams of FIGS. 8 to 14 is omitted.

FIG. 8 is a circuit diagram showing an embodiment of a stage of FIG. 2.

Referring to FIG. 8, a gate driver 300 in embodiments of the inventive concept may include a plurality of stages. Each stage may include an input circuit, a first inversion control circuit, a second inversion control circuit, and a gate output circuit.

The input circuit may provide an input signal IN to a control node NQ in response to a first clock signal CLK1, and the input circuit may include a first transistor T1. The first inversion control circuit may control a voltage of an inversion control node NQB in response to the first clock signal CLK1, and the first inversion control circuit may include a second transistor T2. The second inversion control circuit may control the voltage of the inversion control node NQB in response to the voltage of the control node NQ, and the second inversion control circuit may include a third transistor T3. The gate output circuit may output a gate signal GS in response to the voltage of the control node NQ and the voltage of the inversion control node NQB, and the gate output circuit may include a fourth transistor T4, a fifth transistor T5, a first capacitor C1, and a second capacitor C2. Each stage may further include a node division circuit. The control node NQ1, NQ2 may include a first control node NQ1 and a second control node NQ2, and the node division circuit may be disposed between the first control node NQ1 and the second control node NQ2, and may divide the first control node NQ1 and the second control node NQ2, and the node division circuit may include a sixth transistor T6. The first to sixth transistors T1 to T6 may be PMOS transistors.

The first transistor T1 may include a gate electrode receiving the first clock signal CLK1, a first electrode receiving the input signal IN, and a second electrode connected to the control node NQ1, NQ2.

The second transistor T2 may include a gate electrode connected to the control node NQ1, NQ2, a first electrode, and a second electrode connected to the inversion control node NQB. In an embodiment, the first electrode of the second transistor T2 may receive the first clock signal CLK1.

The third transistor T3 may include a gate electrode receiving the first clock signal CLK1, a first electrode, and a second electrode connected to the inversion control node NQB. In an embodiment, the first electrode of the third transistor T3 may receive the first clock signal CLK1.

The fourth transistor T4 may include a gate electrode connected to the inversion control node NQB, a first electrode receiving a relatively high gate voltage VGH, and a second electrode connected to a gate output node NGS from which the gate signal GS is output.

The fifth transistor T5 may include a gate electrode connected to the control node NQ1, NQ2, a first electrode receiving a second clock signal CLK2, and a second electrode connected to the gate output node NGS.

The first capacitor C1 may include a first electrode receiving the relatively high gate voltage VGH and a second electrode connected to the inversion control node NQB.

The second capacitor C2 may include a first electrode connected to the gate output node NGS and a second electrode connected to the control node NQ1, NQ2.

The control node NQ1, NQ2 may include the first control node NQ1 and the second control node NQ2.

The sixth transistor T6 may include a gate electrode receiving the first clock signal CLK1, a first electrode connected to the first control node NQ1, and a second electrode connected to the second control node NQ2.

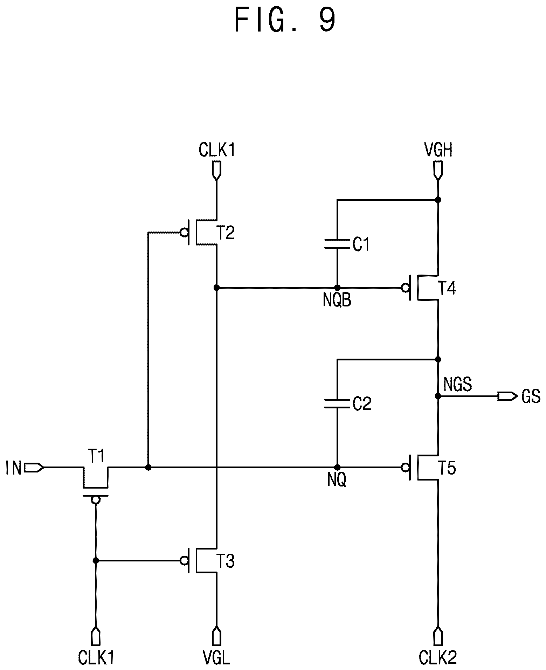

FIG. 9 is a circuit diagram showing an embodiment of a stage of FIG. 2.

Referring to FIG. 9, a gate driver 300 in embodiments of the inventive concept may include a plurality of stages. Each stage may include an input circuit, a first inversion control circuit, a second inversion control circuit, and a gate output circuit.

The input circuit may provide an input signal IN to a control node NQ in response to a first clock signal CLK1, and the input circuit may include a first transistor T1. The first inversion control circuit may control a voltage of an inversion control node NQB in response to the first clock signal CLK1, and the first inversion control circuit may include a second transistor T2. The second inversion control circuit may control the voltage of the inversion control node NQB in response to the voltage of the control node NQ, and the second inversion control circuit may include a third transistor T3. The gate output circuit may output a gate signal GS in response to the voltage of the control node NQ and the voltage of the inversion control node NQB, and the gate output circuit may include a fourth transistor T4, a fifth transistor T5, a first capacitor C1, and a second capacitor C2. The first to fifth transistors T1 to T5 may be PMOS transistors.

The first transistor T1 may include a gate electrode receiving the first clock signal CLK1, a first electrode receiving the input signal IN, and a second electrode connected to the control node NQ.

The second transistor T2 may include a gate electrode connected to the control node NQ, a first electrode, and a second electrode connected to the inversion control node NQB. In an embodiment, the first electrode of the second transistor T2 may receive the first clock signal CLK1.

The third transistor T3 may include a gate electrode receiving the first clock signal CLK1, a first electrode, and a second electrode connected to the inversion control node NQB. In an embodiment, the first electrode of the third transistor T3 may receive a relatively low gate voltage (also referred to as a second gate voltage) VGL.

The fourth transistor T4 may include a gate electrode connected to the inversion control node NQB, a first electrode receiving a relatively high gate voltage VGH, and a second electrode connected to a gate output node NGS from which the gate signal GS is output.

The fifth transistor T5 may include a gate electrode connected to the control node NQ, a first electrode receiving a second clock signal CLK2, and a second electrode connected to the gate output node NGS.

The first capacitor C1 may include a first electrode receiving the relatively high gate voltage VGH and a second electrode connected to the inversion control node NQB.

The second capacitor C2 may include a first electrode connected to the gate output node NGS and a second electrode connected to the control node NQ.

As such, the gate driver 300 may include five transistors, two capacitors, two clock signals, and two gate voltages. Accordingly, configurations may be simplified, and a power consumption and a dead space of the gate driver 300 may be reduced.

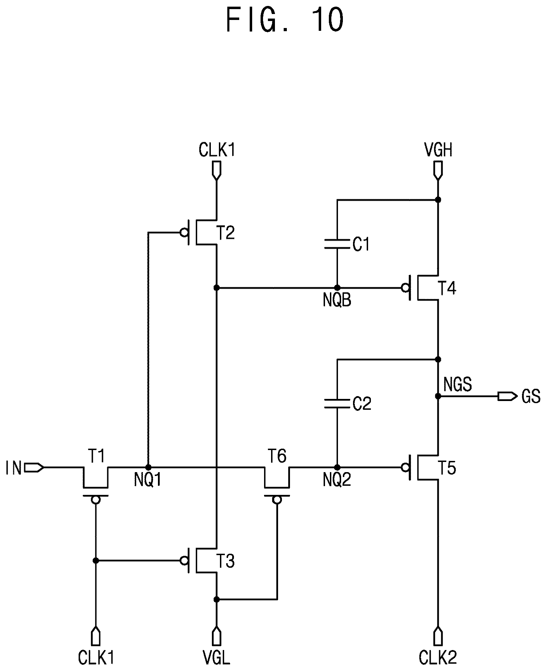

FIG. 10 is a circuit diagram showing an embodiment of a stage of FIG. 2.

Referring to FIG. 10, a gate driver 300 in embodiments of the inventive concept may include a plurality of stages. Each stage may include an input circuit, a first inversion control circuit, a second inversion control circuit, and a gate output circuit.

The input circuit may provide an input signal IN to a control node NQ in response to a first clock signal CLK1, and the input circuit may include a first transistor T1. The first inversion control circuit may control a voltage of an inversion control node NQB in response to the first clock signal CLK1, and the first inversion control circuit may include a second transistor T2. The second inversion control circuit may control the voltage of the inversion control node NQB in response to the voltage of the control node NQ, and the second inversion control circuit may include a third transistor T3. The gate output circuit may output a gate signal GS in response to the voltage of the control node NQ and the voltage of the inversion control node NQB, and the gate output circuit may include a fourth transistor T4, a fifth transistor T5, a first capacitor C1, and a second capacitor C2. Each stage may further include a node division circuit. The control node NQ1, NQ2 may include a first control node NQ1 and a second control node NQ2, and the node division circuit may be disposed between the first control node NQ1 and the second control node NQ2, and may divide the first control node NQ1 and the second control node NQ2, and the node division circuit may include a sixth transistor T6. The first to sixth transistors T1 to T6 may be PMOS transistors.

The first transistor T1 may include a gate electrode receiving the first clock signal CLK1, a first electrode receiving the input signal IN, and a second electrode connected to the control node NQ1, NQ2.

The second transistor T2 may include a gate electrode connected to the control node NQ1, NQ2, a first electrode, and a second electrode connected to the inversion control node NQB. In an embodiment, the first electrode of the second transistor T2 may receive the first clock signal CLK1.

The third transistor T3 may include a gate electrode receiving the first clock signal CLK1, a first electrode, and a second electrode connected to the inversion control node NQB. In an embodiment, the first electrode of the third transistor T3 may receive a relatively low gate voltage VGL.

The fourth transistor T4 may include a gate electrode connected to the inversion control node NQB, a first electrode receiving a relatively high gate voltage VGH, and a second electrode connected to a gate output node NGS from which the gate signal GS is output.

The fifth transistor T5 may include a gate electrode connected to the control node NQ1, NQ2, a first electrode receiving a second clock signal CLK2, and a second electrode connected to the gate output node NGS.

The first capacitor C1 may include a first electrode receiving the relatively high gate voltage VGH and a second electrode connected to the inversion control node NQB.

The second capacitor C2 may include a first electrode connected to the gate output node NGS and a second electrode connected to the control node NQ1, NQ2. The control node NQ1, NQ2 may include the first control node NQ1 and the second control node NQ2.

The sixth transistor T6 may include a gate electrode receiving the relatively low gate voltage VGL, a first electrode connected to the first control node NQ1, and a second electrode connected to the second control node NQ2.

As such, the gate driver 300 may include six transistors, two capacitors, two clock signals, and two gate voltages. Accordingly, configurations may be simplified, and a power consumption and a dead space of the gate driver 300 may be reduced.

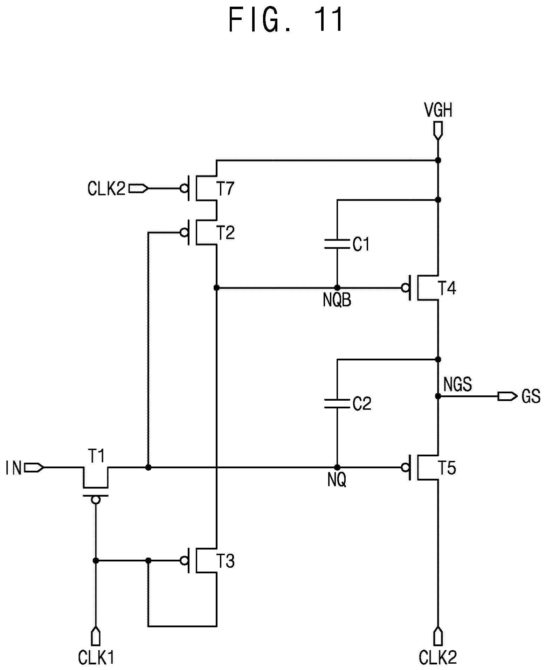

FIG. 11 is a circuit diagram showing an embodiment of a stage of FIG. 2.

Referring to FIG. 11, a gate driver 300 in embodiments of the inventive concept may include a plurality of stages. Each stage may include an input circuit, a first inversion control circuit, a second inversion control circuit, and a gate output circuit.

The input circuit may provide an input signal IN to a control node NQ in response to a first clock signal CLK1, and the input circuit may include a first transistor T1. The first inversion control circuit may control a voltage of an inversion control node NQB in response to the first clock signal CLK1, and the first inversion control circuit may include a second transistor T2 and a seventh transistor T7. The second inversion control circuit may control the voltage of the inversion control node NQB in response to the voltage of the control node NQ, and the second inversion control circuit may include a third transistor T3. The gate output circuit may output a gate signal GS in response to the voltage of the control node NQ and the voltage of the inversion control node NQB, and the gate output circuit may include a fourth transistor T4, a fifth transistor T5, a first capacitor C1, and a second capacitor C2. The first to fifth transistors T1 to T5 and the seventh transistor T7 may be PMOS transistors.

The first transistor T1 may include a gate electrode receiving the first clock signal CLK1, a first electrode receiving the input signal IN, and a second electrode connected to the control node NQ.

The second transistor T2 may include a gate electrode connected to the control node NQ, a first electrode, and a second electrode connected to the inversion control node NQB.

The third transistor T3 may include a gate electrode receiving the first clock signal CLK1, a first electrode, and a second electrode connected to the inversion control node NQB. In an embodiment, the first electrode of the third transistor T3 may receive the first clock signal CLK1.

The fourth transistor T4 may include a gate electrode connected to the inversion control node NQB, a first electrode receiving a relatively high gate voltage VGH, and a second electrode connected to a gate output node NGS from which the gate signal GS is output.

The fifth transistor T5 may include a gate electrode connected to the control node NQ, a first electrode receiving a second clock signal CLK2, and a second electrode connected to the gate output node NGS.

The first capacitor C1 may include a first electrode receiving the relatively high gate voltage VGH and a second electrode connected to the inversion control node NQB.

The second capacitor C2 may include a first electrode connected to the gate output node NGS and a second electrode connected to the control node NQ.

The seventh transistor T7 may include a gate electrode receiving the second clock signal CLK2, a first electrode receiving the relatively high gate voltage VGH, and a second electrode connected to the first electrode of the second transistor T2.

As such, the gate driver 300 may include six transistors, two capacitors, two clock signals, and one gate voltage. Accordingly, configurations may be simplified, and a power consumption and a dead space of the gate driver 300 may be reduced.

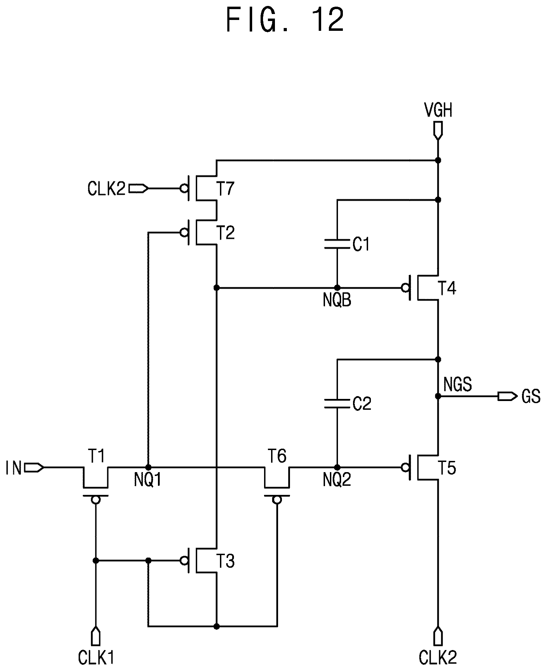

FIG. 12 is a circuit diagram showing an embodiment of a stage of FIG. 2.

Referring to FIG. 12, a gate driver 300 in embodiments of the inventive concept may include a plurality of stages. Each stage may include an input circuit, a first inversion control circuit, a second inversion control circuit, and a gate output circuit.

The input circuit may provide an input signal IN to a control node NQ in response to a first clock signal CLK1, and the input circuit may include a first transistor T1. The first inversion control circuit may control a voltage of an inversion control node NQB in response to the first clock signal CLK1, and the first inversion control circuit may include a second transistor T2 and a seventh transistor T7. The second inversion control circuit may control the voltage of the inversion control node NQB in response to the voltage of the control node NQ, and the second inversion control circuit may include a third transistor T3. The gate output circuit may output a gate signal GS in response to the voltage of the control node NQ and the voltage of the inversion control node NQB, and the gate output circuit may include a fourth transistor T4, a fifth transistor T5, a first capacitor C1, and a second capacitor C2. Each stage may further include a node division circuit. The control node NQ1, NQ2 may include a first control node NQ1 and a second control node NQ2, and the node division circuit may be disposed between the first control node NQ1 and the second control node NQ2 to divide the first control node NQ1 and the second control node NQ2, and the node division circuit may include a sixth transistor T6. The first to seventh transistors T1 to T7 may be PMOS transistors.

The first transistor T1 may include a gate electrode receiving the first clock signal CLK1, a first electrode receiving the input signal IN, and a second electrode connected to the control node NQ1, NQ2.

The second transistor T2 may include a gate electrode connected to the control node NQ1, NQ2, a first electrode, and a second electrode connected to the inversion control node NQB.

The third transistor T3 may include a gate electrode receiving the first clock signal CLK1, a first electrode, and a second electrode connected to the inversion control node NQB. In an embodiment, the first electrode of the third transistor T3 may receive the first clock signal CLK1.

The fourth transistor T4 may include a gate electrode connected to the inversion control node NQB, a first electrode receiving a relatively high gate voltage VGH, and a second electrode connected to a gate output node NGS from which the gate signal GS is output.

The fifth transistor T5 may include a gate electrode connected to the control node NQ1, NQ2, a first electrode receiving a second clock signal CLK2, and a second electrode connected to the gate output node NGS.

The first capacitor C1 may include a first electrode receiving the relatively high gate voltage VGH and a second electrode connected to the inversion control node NQB.

The second capacitor C2 may include a first electrode connected to the gate output node NGS and a second electrode connected to the control node NQ1, NQ2.

The seventh transistor T7 may include a gate electrode receiving the second clock signal CLK2, a first electrode receiving the relatively high gate voltage VGH, and a second electrode connected to the first electrode of the second transistor T2.

The control node NQ1, NQ2 may include the first control node NQ1 and the second control node NQ2.

The sixth transistor T6 may include a gate electrode receiving the first clock signal CLK1, a first electrode connected to the first control node NQ1, and a second electrode connected to the second control node NQ2.

As such, the gate driver 300 may include six transistors, two capacitors, two clock signals, and one gate voltage. Accordingly, configurations may be simplified, and a power consumption and a dead space of the gate driver 300 may be reduced.

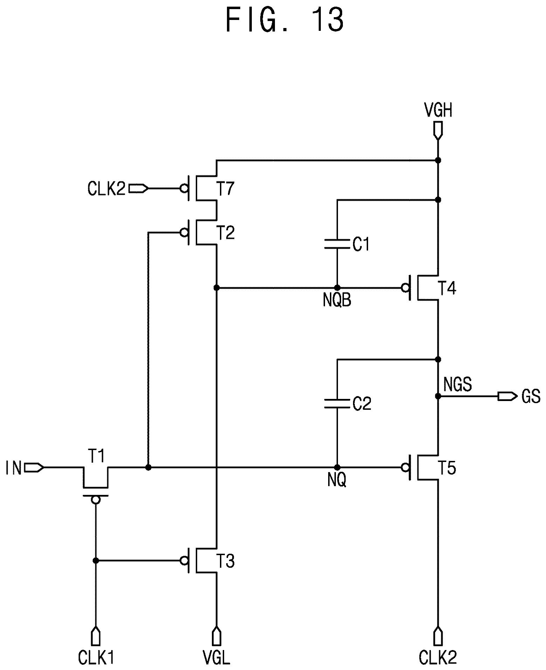

FIG. 13 is a circuit diagram showing an embodiment of a stage of FIG. 2.

Referring to FIG. 13, a gate driver 300 in embodiments of the inventive concept may include a plurality of stages. Each stage may include an input circuit, a first inversion control circuit, a second inversion control circuit, and a gate output circuit.

The input circuit may provide an input signal IN to a control node NQ in response to a first clock signal CLK1, and the input circuit may include a first transistor T1. The first inversion control circuit may control a voltage of an inversion control node NQB in response to the first clock signal CLK1, and the first inversion control circuit may include a second transistor T2 and a seventh transistor T7. The second inversion control circuit may control the voltage of the inversion control node NQB in response to the voltage of the control node NQ, and the second inversion control circuit may include a third transistor T3. The gate output circuit may output a gate signal GS in response to the voltage of the control node NQ and the voltage of the inversion control node NQB, and the gate output circuit may include a fourth transistor T4, a fifth transistor T5, a first capacitor C1, and a second capacitor C2. The first to fifth transistors T1 to T5 and the seventh transistor T7 may be PMOS transistors.

The first transistor T1 may include a gate electrode receiving the first clock signal CLK1, a first electrode receiving the input signal IN, and a second electrode connected to the control node NQ.

The second transistor T2 may include a gate electrode connected to the control node NQ, a first electrode, and a second electrode connected to the inversion control node NQB.

The third transistor T3 may include a gate electrode receiving the first clock signal CLK1, a first electrode, and a second electrode connected to the inversion control node NQB. In an embodiment, the first electrode of the third transistor T3 may receive a relatively low gate voltage VGL.

The fourth transistor T4 may include a gate electrode connected to the inversion control node NQB, a first electrode receiving a relatively high gate voltage VGH, and a second electrode connected to a gate output node NGS from which the gate signal GS is output.

The fifth transistor T5 may include a gate electrode connected to the control node NQ, a first electrode receiving a second clock signal CLK2, and a second electrode connected to the gate output node NGS.

The first capacitor C1 may include a first electrode receiving the relatively high gate voltage VGH and a second electrode connected to the inversion control node NQB.

The second capacitor C2 may include a first electrode connected to the gate output node NGS and a second electrode connected to the control node NQ.

The seventh transistor T7 may include a gate electrode receiving the second clock signal CLK2, a first electrode receiving the relatively high gate voltage VGH, and a second electrode connected to the first electrode of the second transistor T2.

As such, the gate driver 300 may include six transistors, two capacitors, two clock signals, and two gate voltages. Accordingly, configurations may be simplified, and a power consumption and a dead space of the gate driver 300 may be reduced.

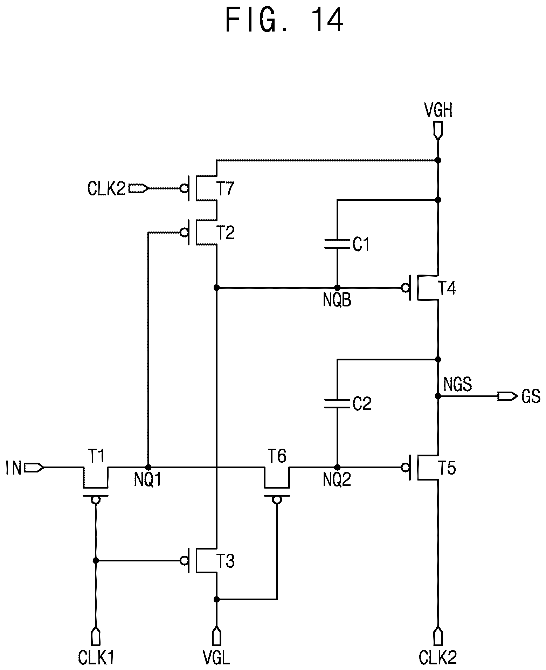

FIG. 14 is a circuit diagram showing an embodiment of a stage of FIG. 2.

Referring to FIG. 14, the gate driver 300 in embodiments of the inventive concept may include a plurality of stages. Each stage may include an input circuit, a first inversion control circuit, a second inversion control circuit, and a gate output circuit.

The input circuit may provide an input signal IN to a control node NQ in response to a first clock signal CLK1, and the input circuit may include a first transistor T1. The first inversion control circuit may control a voltage of an inversion control node NQB in response to the first clock signal CLK1, and the first inversion control circuit may include a second transistor T2 and a seventh transistor T7. The second inversion control circuit may control the voltage of the inversion control node NQB in response to the voltage of the control node NQ, and the second inversion control circuit may include a third transistor T3. The gate output circuit may output a gate signal GS in response to the voltage of the control node NQ and the voltage of the inversion control node NQB, and the gate output circuit may include a fourth transistor T4, a fifth transistor T5, a first capacitor C1, and a second capacitor C2. Each stage may further include a node division circuit. The control node NQ1, NQ2 may include a first control node NQ1 and a second control node NQ2, and the node division circuit may be disposed between the first control node NQ1 and the second control node NQ2, and may divide the first control node NQ1 and the second control node NQ2, and the node division circuit may include a sixth transistor T6. The first to seventh transistors T1 to T7 may be PMOS transistors.

The first transistor T1 may include a gate electrode receiving the first clock signal CLK1, a first electrode receiving the input signal IN, and a second electrode connected to the control node NQ.

The second transistor T2 may include a gate electrode connected to the control node NQ, a first electrode, and a second electrode connected to the inversion control node NQB.

The third transistor T3 may include a gate electrode receiving the first clock signal CLK1, a first electrode, and a second electrode connected to the inversion control node NQB. In an embodiment, the first electrode of the third transistor T3 may receive a relatively low gate voltage VGL.

The fourth transistor T4 may include a gate electrode connected to the inversion control node NQB, a first electrode receiving a relatively high gate voltage VGH, and a second electrode connected to a gate output node NGS from which the gate signal GS is output.

The fifth transistor T5 may include a gate electrode connected to the control node NQ, a first electrode receiving a second clock signal CLK2, and a second electrode connected to the gate output node NGS.

The first capacitor C1 may include a first electrode receiving the relatively high gate voltage VGH and a second electrode connected to the inversion control node NQB.

The second capacitor C2 may include a first electrode connected to the gate output node NGS and a second electrode connected to the control node NQ.

The seventh transistor T7 may include a gate electrode receiving the second clock signal CLK2, a first electrode receiving the relatively high gate voltage VGH, and a second electrode connected to the first electrode of the second transistor T2.

The control node NQ1, NQ2 may include the first control node NQ1 and the second control node NQ2.

The sixth transistor T6 may include a gate electrode receiving the relatively low gate voltage VGL, a first electrode connected to the first control node NQ1, and a second electrode connected to the second control node NQ2.

As such, the gate driver 300 may include seven transistors, two capacitors, two clock signals, and two gate voltages. Accordingly, configurations may be simplified, and a power consumption and a dead space of the gate driver 300 may be reduced.

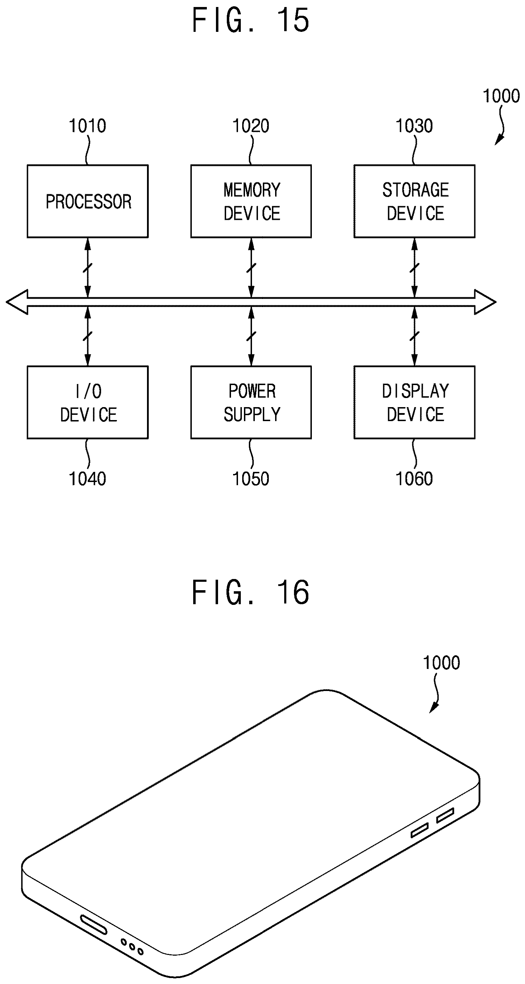

FIG. 15 is a block diagram showing an electronic device 1000. FIG. 16 is a diagram showing an embodiment in which an electronic device 1000 of FIG. 15 is implemented as a smart phone.

Referring to FIG. 15 and FIG. 16, an electronic device 1000 may include a processor 1010, a memory device 1020, a storage device 1030, an input/output ("I/O") device 1040, a power supply 1050, and a display device 1060. The display device 1060 may be the display device 10 of FIG. 1. In addition, the electronic device 1000 may further include a plurality of ports for communicating with a video card, a sound card, a memory card, a universal serial bus USB device, other electronic device, or the like.

In an embodiment, as described in FIG. 16, the electronic device 1000 may be implemented as the smart phone. However, the electronic device 1000 is not limited thereto. In an embodiment, the electronic device 1000 may be implemented as a cellular phone, a video phone, a smart pad, a smart watch, a tablet personal computer ("PC"), a car navigation system, a computer monitor, a laptop, a head mounted display ("HMD") device, or the like, for example.

The processor 1010 may perform various computing functions. The processor 1010 may be a micro processor, a central processing unit ("CPU"), an application processor ("AP"), or the like. The processor 1010 may be coupled to other components via an address bus, a control bus, a data bus, or the like. Further, the processor 1010 may be coupled to an extended bus such as a peripheral component interconnection ("PCI") bus.

The memory device 1020 may store data for operations of the electronic device 1000. In an embodiment, the memory device 1020 may include at least one nonvolatile memory device such as an erasable programmable read-only memory ("EPROM") device, an electrically erasable programmable read-only memory ("EEPROM") device, a flash memory device, a phase change random access memory ("PRAM") device, a resistance random access memory ("RRAM") device, a nano floating gate memory ("NFGM") device, a polymer random access memory ("PoRAM") device, a magnetic random access memory ("MRAM") device, a ferroelectric random access memory ("FRAM") device, or the like and/or at least one volatile memory device such as a dynamic random access memory ("DRAM") device, a static random access memory ("SRAM") device, a mobile ("DRAM") device, or the like, for example.

The storage device 1030 may include a solid state drive ("SSD") device, a hard disk drive ("HDD") device, a compact disc read-only memory ("CD-ROM") device, or the like.

The I/O device 1040 may include an input device such as a keyboard, a keypad, a mouse device, a touch-pad, a touch-screen, or the like, and an output device such as a printer, a speaker, or the like. In some embodiments, the I/O device 1040 may include the display device 1060.

The power supply 1050 may provide power for operations of the electronic device 1000.

The display device 1060 may be connected to other components through buses or other communication links.

The inventive concepts may be applied to any display device and any electronic device including the touch panel. In an embodiment, the inventive concepts may be applied to a mobile phone, a smart phone, a tablet computer, a digital television ("TV"), a three dimensional ("3D") TV, a personal computer PC, a home appliance, a laptop computer, a personal digital assistant ("PDA"), a portable multimedia player ("PMP"), a digital camera, a music player, a portable game console, a navigation device, etc., for example.

The foregoing is illustrative of the inventive concept and is not to be construed as limiting thereof. Although a few embodiments of the inventive concept have been described, those skilled in the art will readily appreciate that many modifications are possible in the embodiments without materially departing from the novel teachings and advantages of the inventive concept. Accordingly, all such modifications are intended to be included within the scope of the inventive concept as defined in the claims. In the claims, means-plus-function clauses are intended to cover the structures described herein as performing the recited function and not only structural equivalents but also equivalent structures. Therefore, it is to be understood that the foregoing is illustrative of the inventive concept and is not to be construed as limited to the illustrative embodiments disclosed, and that modifications to the disclosed embodiments, as well as other embodiments, are intended to be included within the scope of the appended claims. The inventive concept is defined by the following claims, with equivalents of the claims to be included therein.

## Claims

1. A gate driver (300) including a plurality of stages, each of the plurality of stages comprising:
an input circuit configured to provide an input signal to a control node (NQ) in response to a first clock signal;
a first inversion control circuit configured to control a voltage of an inversion control node (NQB) in response to a voltage of the control node; and
a gate output circuit configured to output a gate signal in response to the voltage of the control node and the voltage of the inversion control node.

2. The gate driver (300) of claim 1, wherein the input circuit comprises a first transistor (T1) including a gate electrode which is configured to receive the first clock signal, a first electrode which is configured to receive the input signal, and a second electrode connected to the control node,
the first inversion control circuit comprises a second transistor (T2) including a gate electrode connected to the control node, a first electrode, and a second electrode connected to the inversion control node, and
the gate output circuit comprises:
a fourth transistor (T4) including a gate electrode connected to the inversion control node, a first electrode which is configured to receive a first gate voltage having a first level which is relatively high, and a second electrode connected to a gate output node from which the gate signal is output; and
a fifth transistor (T5) including a gate electrode connected to the control node, a first electrode which is configured to receive a second clock signal, and a second electrode connected to the gate output node.

3. The gate driver (300) of claim 2, wherein the each of the plurality of stages further comprises a second inversion control circuit configured to control the voltage of the inversion control node in response to the first clock signal, and
the second inversion control circuit comprises a third transistor (T3) including a gate electrode which is configured to receive the first clock signal, a first electrode, and a second electrode connected to the inversion control node.

4. The gate driver (300) of claim 2 or 3, wherein the first to fifth transistors are p-type metal oxide semiconductor transistors.

5. The gate driver (300) of any of the preceding claims, wherein the gate output circuit further comprises a first capacitor (C1) including a first electrode which is configured to receive the first gate voltage and a second electrode connected to the inversion control node.

6. The gate driver (300) of any of the preceding claims, wherein the gate output circuit further comprises a first electrode connected to the gate output node and a second capacitor (C2) connected to the control node.

7. The gate driver (300) of any of claims 3 to 6, wherein the first electrode of the second transistor (T2) is configured to receive the first clock signal, and the first electrode of the third transistor (T3) is configured to receive the first clock signal.

8. The gate driver (300) of claim 7, wherein the control node includes a first control node (NQ1) and a second control node (NQ2),
the each of the plurality of stages further comprises a node division circuit disposed between the first control node (NQ1) and the second control node (NQ2) and configured to divide the first control node and the second control node, and
the node division circuit comprises a sixth transistor (T6) including a gate electrode which is configured to receive the first clock signal, a first electrode connected to the first control node, and a second electrode connected to the second control node.

9. The gate driver (300) of any of the claims 3 to 6, wherein the first electrode of the second transistor (T2) is configured to receive the first clock signal, and the first electrode of the third transistor (T3) is configured to receive a second gate voltage having a second level lower than the first level of the first gate voltage.

10. The gate driver (300) of claim 9, wherein the control node includes a first control node (NQ1) and a second control node (NQ2),
the each of the plurality of stages further comprises a node division circuit disposed between the first control node and the second control node and configured to divide the first control node and the second control node, and
the node division circuit comprises a sixth transistor (T6) including a gate electrode which is configured to receive the second gate voltage, a first electrode connected to the first control node, and a second electrode connected to the second control node.

11. The gate driver (300) of any of claims 3 to 6, wherein the first electrode of the third transistor (T3) is configured to receive the first clock signal, and
the first inversion control circuit further comprises a seventh transistor (T7) including a gate electrode which is configured to receive the second clock signal, a first electrode which is configured to receive the first gate voltage, and a second electrode connected to the first electrode of the second transistor.

12. The gate driver (300) of claim 11, wherein the control node includes a first control node (NQ1) and a second control node (NQ1),
the each of the plurality of stages further comprises a node division circuit disposed between the first control node and the second control node and configured to divide the first control node and the second control node, and
the node division circuit comprises a sixth transistor (T6) including a gate electrode which is configured to receive the first clock signal, a first electrode connected to the first control node, and a second electrode connected to the second control node.

13. The gate driver (300) of any of claims 3 to 6, wherein the first electrode of the third transistor (T3) is configured to receive a second gate voltage having a second level lower than the first level of the first gate voltage, and
the first inversion control circuit further comprises a seventh transistor (T7) including a gate electrode which is configured to receive the second clock signal, a first electrode which is configured to receive the first gate voltage, and a second electrode connected to the first electrode of the second transistor.

14. The gate driver (300) of claim 13, wherein the control node includes a first control node (NQ1) and a second control node (NQ1),
the each of the plurality of stages further comprises a node division circuit disposed between the first control node and the second control node and configured to divide the first control node and the second control node, and
the node division circuit comprises a sixth transistor (T6) including a gate electrode which is configured to receive thesecond gate voltage, a first electrode connected to the first control node, and a second electrode connected to the second control node.

15. A display device comprising:
a display panel (100) including pixels,
a data driver (500) configured to provide a data voltage to the pixels,
a gate driver (300) of any of the proceeding claims, the gate driver being configured to provide a gate voltage to the pixels, and
a driving controller (200) configured to control the data driver and the gate driver (300).
